Europäisches Patentamt

European Patent Office

Office européen des brevets

(11) Publication number : **0 628 834 A1**

(19)

# (12) EUROPEAN PATENT APPLICATION

(21) Application number : **94304032.9**

(22) Date of filing : **06.06.94**

(51) Int. Cl.⁵ : **G01R 31/36**

(30) Priority : **10.06.93 GB 9312000**

(43) Date of publication of application :
**14.12.94 Bulletin 94/50**

(84) Designated Contracting States :
**DE FR GB**

(71) Applicant : **NOKIA MOBILE PHONES LTD.**
**P.O. Box 86**
**SF-24101 Salo (FI)**

(72) Inventor : **McKillop, Tony**
**2 Moores Green**
**Wokingham, Berkshire RG1 1 1QG (GB)**

(74) Representative : **Frain, Timothy John et al**
**Nokia Mobile Phones,**
**St. George's Court,**
**St. George's Road,**
**9 High Street**
**Camberley, Surrey GU15 3QZ (GB)**

(54) **Battery operated apparatus with charge monitor.**

(57) A battery operated apparatus comprising a display and a battery state monitor for producing a signal indicative of the battery charge state. The display is illuminated by light having one of two or more predetermined characteristics associated therewith. The characteristics of the light with which the display is illuminated depend on the battery charge state signal. Thus information on the battery charge state can clearly and easily be obtained merely by observing the background illumination of the display.

Fig.1.

EP 0 628 834 A1

This invention relates to a battery operated apparatus having a battery state monitor.

A battery state monitor can be applicable to any battery operated apparatus. However, it is particularly useful in an apparatus such as a radio telephone in which it is advantageous to have an early warning of a reduction in battery charge to a level where the battery will shortly need to be replaced or recharged.

Present radio telephones have displays which provide information to the user including, in the case of radio telephones which have a battery state monitor, a visual display of the battery state. This visual display may comprise a bar-like indicator, the height of which gradually decreases with decreasing battery voltage.

When a state of the art radio telephone is being used the battery state information is presented during the call initiating stage prior to a call being connected. For outgoing calls the telephone display generally shows the number being called and possibly other information such as the volume. There is generally no continuous display of battery charge state during a telephone call. Consequently, should a user have failed to notice the battery state indication before making a telephone call the performance may deteriorate to the point where the telephone may cease to function during the call.

The charge state of a battery can be measured by measuring the voltage provided by the battery. As the battery is discharged the battery voltage is initially substantially constant. However, as the battery charge begins to be depleted the battery voltage provided by the battery will also begin to reduce, until the battery charge is so low that a diminishingly small battery voltage is provided by the battery.

Also in radio telephones space on the display is limited particularly as the trend in radio telephones is towards smaller handsets. Thus a means which enables information regarding battery state to be displayed without requiring a portion of the display to be dedicated to this function would be advantageous.

According to the present invention there is provided a battery operated apparatus comprising a display region illuminated by means for lighting operable in any one of a plurality of modes, the mode of illumination of the region being responsive to a signal indicative of the charge state of the battery.

Thus in the case where the battery operated apparatus is a radio telephone information regarding battery state may be conveyed conveniently to the user during a call as well as prior to a call. Also, as the displays in most battery operated devices such as radio telephones are back-lit, in one colour in any case, the battery state monitor in accordance with the invention may be incorporated using the original back-lighting arrangement of the device with a minimum of additional components.

Furthermore, the invention also provides a very prominent way of signalling to the user when battery charge state is low.

Preferably there is a first and a second predetermined voltage range corresponding to a battery high state and a battery low state respectively.

Such a monitor provides an indication of change in battery charge state which is clear and easy to understand.

In addition there might be a third predetermined voltage range, being between the first and second voltage ranges, corresponding to an intermediate battery state.

The additional intermediate voltage range provides additional information on the state of the battery for the user, i.e. an earlier warning of the reduction in battery charge state.

Preferably the means for lighting is adapted so as to illuminate the display with light of one of two or more predetermined colours such that the colour of light with which the display is illuminated is dependent on the battery state signal from the comparator.

Alternatively the means for lighting may be adapted so as to illuminate the display with pulses of light, with one of two or more predetermined repetition rates, such that the repetition rate of the light with which the display is illuminated is dependent on the battery state signal from the comparator.

If pulsed light is used preferably one of the repetition rates is such that the display appears to be substantially constantly illuminated.

The display may be a textual or graphic display or any display giving information in addition to illumination information.

An embodiment of the present invention is described below, by way of example, with reference to the accompanying drawings, in which:

Figure 1 is a block diagram of a battery state monitor in accordance with the present invention; and

Figure 2 is a circuit diagram of the battery state monitor of Figure 1.

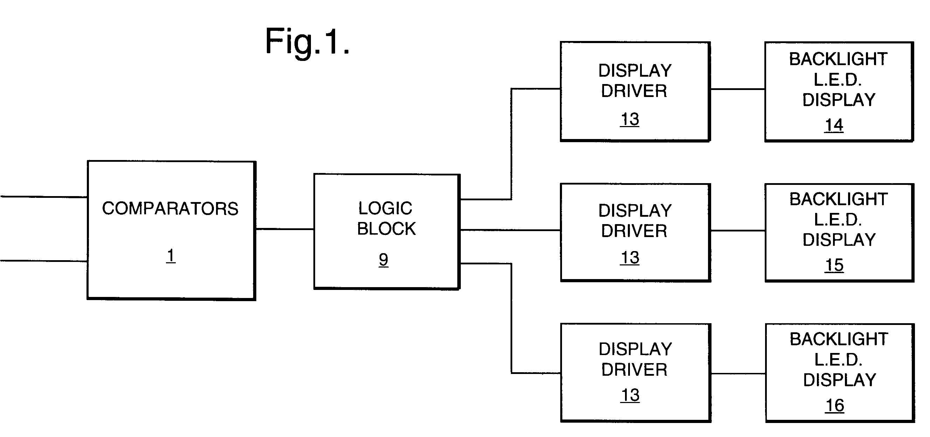

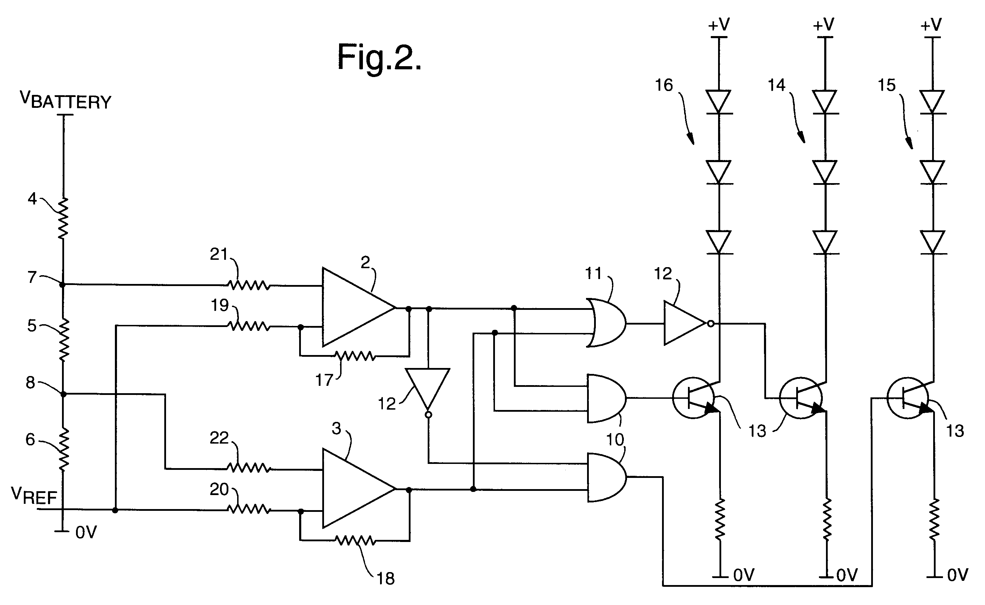

Figure 1 and Figure 2 illustrate a battery state monitor, suitable for use with a battery operated apparatus, comprising a comparator block, having a first comparator 2 and a second comparator 3. The battery voltage is compared with a reference voltage, in each of the first and second comparators 2 and 3 to produce a battery state signal indicative of the battery voltage being within one of three predetermined voltage ranges. The comparator is coupled to means for illuminating the display of the battery operated apparatus with light, in the form of three arrays of light emitting diodes 14,15 and 16. In this embodiment the characteristic of the light which is altered for each of the different voltage ranges is wavelength. An array of green LEDs 14 is utilized for the voltage range corresponding to acceptable battery state. An array of yellow LEDs 15 is utilized for the voltage range corresponding to intermediate battery charge state and an array of red LEDs 16 is utilized for the voltage range corresponding to low battery charge state.

A decrease in the telephone performance may be due to low battery charge state. Also if the battery charge state is low the telephone may cease to function without warning and it would be advantageous for the user to be aware of the battery charge state throughout a telephone conversation so that he may anticipate the failure of the telephone and replace the battery prior to this occurring.

Figure 2 shows a circuit diagram of a battery state monitor in accordance with the present invention comprising a comparator block 1 having two comparators 2 and 3. The comparator block 1 also comprises three series coupled resistors 4, 5 and 6, such that the voltage at a first point 7 between the first and second resistors 4 and 5 is higher than that at a second part 8 between the second and third resistors 5 and 6.

The reference voltage is derived by standard means and supplied to the first and second comparators 2 and 3 via resistors 19 and 20 respectively.

The inputs of the first comparator 2 are a reference voltage, with which the battery voltage is to be compared, and a signal taken from the first point 7 via resistor 21. The inputs of the second comparator 3 are the reference voltage and a signal taken from the second point 8 via resistor 22. For the first voltage range, in which the battery is charged to a substantial level the voltage at the first and at the second points will be greater than the reference voltage and the output of both comparator will be a logic 0.

When the battery is charged to the intermediate level the voltage at the first point 6 will be greater that the reference voltage and the voltage at the second point 7 will be less than the reference voltage and the output of the first comparator 2 will be a logic 0 and the output of the second comparator 3 will be a logic 1.

When the battery charge state is low the voltage at the first and second points 7 and 8 will be less than the reference voltage and the output of both comparators will be a logic 1.

Resistance means 17 and 18 provide an element of voltage hysteresis around the first and second comparators 2 and 3 respectively, thus minimizing uncertainty in the change point wherein the battery voltage is substantially equal to the reference voltage.

The outputs of the comparators 2 and 3 are coupled to a logic circuit 9 which is in turn coupled to the inputs of three arrays of LEDs 14, 15 and 16, only one of which should be lit for each battery state to be indicated. The LEDs "backlight" the LCD. These LEDs are typically located to the side of the display region but could equally be positioned behind the display region.

The logic circuit 9 comprises AND gates 10, OR gates 11 and invertor gates 12, as illustrated in Figure 2.

The characteristics of the gates being as follows

AND
$$\underline{0 \quad 0 \quad 1} \text{ output}$$
$$0 \quad 0 \quad 1 \,)_{\text{ inputs}}$$
$$1 \quad 0 \quad 1 \,)$$

OR
$$\underline{0 \quad 1 \quad 1} \text{ outputs}$$
$$0 \quad 0 \quad 1 \,)_{\text{ inputs}}$$
$$0 \quad 1 \quad 1 \,)$$

INVERT
$$\underline{0 \quad 1} \text{ output}$$
$$1 \quad 0 \quad \text{ input}$$

The logic block 9 receives inputs from the comparators 2 and 3 and produces discrete logic outputs to drive the LEDs via buffer transistors 13.

Simple transistor buffer/drivers may be used here. If the logic supply voltage is suitably regulated and reasonably lower than the battery voltage it may be used to provide simple constant current sinking to the LEDs by resistive emitter biassing.

From the circuit diagram of Figure 2 it is clear that LEDs 14 only are lit when the battery state is high, LEDs 15 only are lit when the battery state is intermediate, and LEDs 16 only are lit when the battery state is low.

In view of the foregoing it will be clear to a person skilled in the art that modifications may be incorporated without departing from the scope of the present invention. For example, instead of three separate arrays of LEDs of different colours a tri-colour LED may be used. Also if an intermediate charge indication is not required two separate arrays of LEDs of different colours or a bi-colour LED may be used. Also change in charge state may be displayed by blinking or fading the back light as opposed to changing its colour. In addition, the embodiment described herein shows discrete logic gates however the logic circuit 9 may be constructed by a combination of logic gates in a single package.

Finally the invention can be applied to the illumination of a different region of a battery operated device such as the key pad of a radio telephone.

## Claims

1. A battery operated apparatus comprising a display region illuminated by means for lighting operable in any one of a plurality of modes, the mode of illumination of the region being responsive to a signal indicative of the charge state of the battery.

2. A battery operated apparatus according to claim 1 wherein the modes of illumination comprise respective colours.

3. A battery operated apparatus according to any preceding claim wherein the modes of illumination comprise respective pulsing frequencies.

4. A battery operated apparatus according to claim 3 wherein in one of the plurality of modes the pulsing frequency is such that the illumination appears to be substantially continuous.

5. A battery operated apparatus according to any preceding claim wherein the signal indicative of the charge state of the battery indicates a respective range of battery voltage levels for each of the plurality of modes.

6. A battery operated apparatus according to any preceding claim wherein the battery voltage is compared with a reference voltage to provide the signal indicative of the battery charge state.

7. A battery operated apparatus according to any preceding claim wherein the illumination is effected by backlighting.

8. A battery operated apparatus according to any preceding claim wherein the display region comprises a liquid crystal display.

9. A battery operated apparatus according to any preceding claim wherein the display region comprises a key pad.

10. A battery operated apparatus according to any one of the preceding claims wherein the battery operated apparatus comprises a radio telephone.

Fig.1.

COMPARATORS
1

LOGIC BLOCK
9

DISPLAY DRIVER
13

DISPLAY DRIVER
13

DISPLAY DRIVER
13

BACKLIGHT L.E.D. DISPLAY
14

BACKLIGHT L.E.D. DISPLAY
15

BACKLIGHT L.E.D. DISPLAY
16

Fig.2.

**European Patent Office**

**EUROPEAN SEARCH REPORT**

Application Number

EP 94 30 4032

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | PATENT ABSTRACTS OF JAPAN vol. 17, no. 203 (E-1354) 21 April 1993 & JP-A-04 346 545 (NEC) 2 December 1992 * abstract * | 1,2,7,8,10 | G01R31/36 |
| Y | | 3,5,6 | |
| Y | ELECTRONICS. DE 1984 A 1985 : ELECTRONICS WEEK, vol.46, no.8, 12 April 1973, NEW YORK US page 106 THAI 'ONE LAMP CAN MONITOR BATTERY VOLTAGE' * the whole document * | 3,5,6 | |
| A | US-A-4 019 112 (SATOH) * column 3, line 19 - line 40 * * column 6, line 7 - line 13 * | 1,3,4,6 | |
| A | WO-A-91 19190 (COSS CORPORATION) * abstract * | 1-6 | |
| A | US-A-4 043 112 (TANAKA) * column 3, line 29 - line 43 * | 1,3,6 | TECHNICAL FIELDS SEARCHED (Int.Cl.5) G01R |

The present search report has been drawn up for all claims

| Place of search | Date of completion of the search | Examiner |
|---|---|---|
| THE HAGUE | 21 September 1994 | Iwansson, K |

EPO FORM 1503 03.82 (P04C01)